Europäisches Patentamt

European Patent Office

Office européen des brevets

(19)

(11) **EP 0 504 062 B1**

(12) **FASCICULE DE BREVET EUROPEEN**

(45) Date de publication et mention
de la délivrance du brevet:
**03.01.1996  Bulletin 1996/01**

(51) Int Cl.6: **H03H 11/28**, H04B 3/02,
G06F 13/38

(21) Numéro de dépôt: **92400661.2**

(22) Date de dépôt: **12.03.1992**

(54) **Circuit intégré à impédances asservies et application aux émetteurs-récepteurs, notamment pour la communication entre unités d'un système informatique**

Integrierte Schaltung mit servogesteuerten Impedanzen und Anwendung für Senderempfänger, insbesondere für die Kommunikation zwischen Einheiten eines Informationssystems

Integrated circuit with servo-controlled impedances and application to transceivers, particularly for communication between units of an information system

(84) Etats contractants désignés:
**DE FR GB IT NL SE**

(30) Priorité: **14.03.1991 FR 9103125**

(43) Date de publication de la demande:
**16.09.1992  Bulletin 1992/38**

(73) Titulaire: **BULL S.A.**
**F-78430 Louveciennes (FR)**

(72) Inventeur: **Marbot, Roland**
**F-75116 Paris (FR)**

(74) Mandataire: **Colombe, Michel et al**
**F-78430 Louveciennes (FR)**

(56) Documents cités:
**DE-A- 2 923 277**

- **PATENT ABSTRACTS OF JAPAN vol. 7, no. 280 (E-216) 14 Décembre 1983 & JP-A-58 159 016**
- **PATENT ABSTRACTS OF JAPAN vol. 4, no. 75 (E-013) & JP-A-55 042 480**

**Description**

L'invention concerne les circuits intégrés dans lesquels on cherche à réaliser des impédances, telles que des résistances, ayant des valeurs déterminées avec précision.

Ce problème se rencontre dans de nombreuses applications où une partie du circuit intégré est de type analogique. Par exemple, pour réaliser des circuits à retard intégrés, on utilise des circuits à constante de temps du type résistance-capacité et pour obtenir une valeur précise de la constante de temps, il est nécessaire que les éléments résistifs et capacitifs du circuit aient des valeurs bien précises.

Une autre application importante concerne la réalisation intégrée d'émetteurs-récepteurs servant à la transmission de signaux par l'intermédiaire de lignes de transmission. Il est alors généralement nécessaire de prévoir au niveau du récepteur une impédance d'adaptation dont la valeur est égale à l'impédance caractéristique de la ligne de façon à supprimer ou limiter la réflection des signaux. Or, dans les réalisations connues jusqu'à présent, l'impédance d'adaptation est externe au circuit intégré précisément à cause de la difficulté de réaliser des impédances ayant une valeur bien précise. Cependant, si l'on veut réaliser un émetteur-récepteur intégré capable de fonctionner à haut débit, par exemple de l'ordre de 1 Gbit/s, l'utilisation d'une impédance d'adaptation externe entraîne des difficultés notamment dues aux inductances parasites introduites par les connexions entre l'impédance et les bornes du circuit intégré. Il est par conséquent souhaitable de pouvoir réaliser une impédance d'adaptation intégrée mais on retrouve le problème de pouvoir ajuster précisément sa valeur.

On sait qu'un dimensionnement précis des composants appartenant à un circuit intégré ne permet pas d'obtenir des caractéristiques précises de ces composants à cause des dispersions de fabrication ainsi que des dérives des caractéristiques par vieillissement ou variation de température.

Ainsi, le but de l'invention est de proposer une solution à ce problème.

On pourrait envisager une réalisation consistant à utiliser des impédances réglables commandées par une valeur numérique de réglage chargée initialement dans le circuit intégré lors de sa mise sous tension, cette valeur de réglage étant déterminée en effectuant des opérations de test recherchant la valeur numérique de réglage qui fait prendre aux impédances réglables la valeur la plus proche de la valeur recherchée. Les dispersions de fabrication peuvent alors être compensées. Par contre, cette solution ne prend pas en compte les dérives des caractéristiques par vieillissement ou variations de température. De plus, elle nécessite d'effectuer un test sur chaque circuit intégré fabriqué.

On peut aussi envisager de prévoir à l'intérieur du circuit intégré un circuit de compensation des dispersions conçu de façon à corriger le réglage des impédances variables en fonction d'une mesure des caractéristiques électriques d'un composant du circuit représentatif de la fabrication. Cette solution permet, dans une certaine mesure, de compenser les dispersions de fabrication et les dérives. Mais la correction ne peut être qu'approximative et ne permet pas une grande précision sur la valeur des impédances.

L'abrégé du document japonais JP-58159016 propose de remplacer les résistances d'un filtre intégré par des circuits à résistance variable. Ces circuits sont constitués d'amplificateurs. En contrôlant le gain analogique A de ces amplificateurs pour l'égaler à celui d'un amplificateur identique branché à l'une de ses entrées sur une résistance calibrée, les circuits présentent une résistance équivalente d'entrée dont la valeur coïncide avec celle de la résistance calibrée. Cependant la tension entre la borne d'entrée et la borne de sortie de ces circuits n'est pas proportionnelle avec un coefficient constant au courant les traversant entre ces deux bornes. Il est donc difficile d'étendre leur utilisation à des applications nécessitant des éléments intégrés à comportement réel de résistance telles qu'on en trouve dans le domaine des hautes fréquences (circuits à retard, émetteurs-récepteurs ou autres).

Aussi l'invention propose une autre solution qui ne présente pas les inconvénients précédents. Dans ce but, l'invention a pour objet un circuit intégré comportant au moins une impédance intégrée réglable et des moyens d'asservissement pour régler ladite ou lesdites impédances à une valeur fonction de celle d'une impédance de référence extérieure au circuit intégré, l'invention étant réalisée par des circuits caractérisés par les revendications ci-jointes.

L'asservissement mentionné ci-dessus peut être réalisé de multiples façons mais nécessite en principe la comparaison entre la valeur des impédances à régler et celle de référence. En pratique, une telle comparaison implique l'alimentation de ces impédances par un courant ou une tension et la mesure, selon le cas, de la tension à leurs bornes ou des courants qui y circulent. Or, les impédances que l'on cherche à régler sont elles-mêmes alimentées par les circuits qui les utilisent. Par conséquent, la comparaison de l'impédance à régler à celle de référence peut difficilement utiliser les impédances à régler.

Or, dans un même circuit intégré, tous les composants de dimensionnements identiques ou proportionnels présentent des caractéristiques réelles pratiquement identiques ou proportionnelles entre elles, indépendamment des dispersions de fabrication et des dérives. Cette propriété des circuits intégrés peut alors être exploitée pour résoudre le problème précédent en prévoyant une impédance d'asservissement de dimensionnement identique ou proportionnel à celui des impédances à régler et on utilisera cette impédance pour effectuer la comparaison et en déduire une valeur de réglage qui sera appliquée à la fois à l'impédance d'asservissement et aux impédances à régler.

Aussi, selon l'invention, lesdits moyens d'asservissement comportent une impédance d'asservissement réglable et intégrée et dont le dimensionnement est fonction de celui des impédances intégrées réglables et un comparateur d'impédance comparant la valeur de l'impédance d'asservissement à celle de l'impédance de référence et fournissant en fonction de cette comparaison un signal de réglage pour régler ladite impédance d'asservissement et lesdites impédances intégrées réglables.

Pour de nombreuses applications, les impédances sont des résistances pures ou bien on cherche surtout à fixer la partie résistive des impédances. Tel est le cas des impédances d'adaptation à des lignes pratiquement sans pertes. Dans ces circonstances, la réalisation est simplifiée. Ainsi, le rapport du dimensionnement (en largeur ou en longueur) de l'impédance d'asservissement à celui de chaque impédance à régler déterminera le rapport de leurs valeurs réelles et comme l'asservissement fixe la valeur réelle de l'impédance d'asservissement, on peut fixer ainsi la valeur de chaque impédance.

Selon l'invention, le circuit intégré est caractérisé en ce que ledit comparateur d'impédance comporte des moyens d'alimentation en courant de l'impédance d'asservissement et de l'impédance de référence et un comparateur de tension sensible à la différence entre respectivement la tension aux bornes de l'impédance d'asservissement et celle aux bornes de l'impédance de référence.

Cette comparaison implique la mesure des tensions aux bornes des impédances et cette mesure peut être effectuée par l'intermédiaire de ponts diviseurs de tension intégrés. En jouant sur les rapports de division des ponts, on peut aussi fixer le rapport entre la valeur de l'impédance de référence et celle de l'impédance d'asservissement. Ce rapport pourrait également être fixé en jouant sur les valeurs relatives des courants alimentant respectivement l'impédance de référence et l'impédance d'asservissement.

D'autre part, pour réaliser des impédances variables, on pourrait imaginer une solution analogique utilisant par exemple des transistors PMOS, la résistance des chemins drain-source constituant la partie résistive des impédances réglables, les grilles étant commandées par un signal de réglage analogique représentatif de la différence entre la valeur de l'impédance de référence et celle de l'impédance d'asservissement. Or, cette solution présente l'inconvénient que le signal de réglage analogique est exposé à des altérations lors de sa transmission dans le circuit, en particulier dans le cas d'un circuit intégré comportant un grand nombre d'impédances à régler.

Aussi, pour remédier à cet inconvénient, le signal de réglage des impédances variables est un signal numérique.

L'utilisation de transistors PMOS réglés par leur tension de grille pour réaliser des résistances réglables imposerait, dans le cas d'un signal de réglage numérique, de leur associer des circuits de conversion numérique-analogique. Bien que cette solution soit envisageable, une réalisation entièrement numérique est préférable.

Dans ce but et selon un autre aspect de l'invention, chaque impédance réglable est réalisée au moyen d'une pluralité de résistances intégrées branchées sélectivement en parallèle en fonction du signal de réglage numérique. Dans ce cas, chacune des résistances intégrées peut être réalisée au moyen d'un transistor PMOS sélectionné par son signal de grille.

On pourrait d'autre part imaginer de choisir un dimensionnement de ces résistances de façon à réaliser une pondération d'un code binaire (les résistances sont toutes différentes et proportionnelles à une puissance de 2) de façon à réduire le nombre de lignes de commande pour une précision donnée. Cependant, cette solution pose le problème des commutations simultanées de plusieurs résistances qui pourraient provoquer des perturbations au niveau des lignes. Pour éviter ce problème, il est préférable d'utiliser des résistances dimensionnées de façon à ce que leurs activations successives conduisent à des valeurs régulièrement décroissantes de la résistance équivalente en résultant.

Il convient d'autre part d'éviter les instabilités dans l'asservissement des impédances. Pour cela, il suffit de produire un effet d'hystérésis dans le réglage des impédances. Ainsi, selon un aspect particulier de réalisation de l'invention, le comparateur de tension délivre un signal d'incrémentation et un signal de décrémentation et active ledit signal d'incrémentation ou de décrémentation lorsque la différence de tension indique que la valeur de l'impédance d'asservissement est respectivement inférieure ou supérieure à la valeur de l'impédance de référence d'une valeur de seuil déterminée, en ce que lesdits moyens d'asservissement comportent un compteur-décompteur et en ce que lesdits signaux d'incrémentation et de décrémentation sont appliqués respectivement aux entrées d'incrémentation et de décrémentation dudit compteur-décompteur de façon à ce que son état constitue ledit signal de réglage numérique représentatif du nombre de résistances à sélectionner dans chaque impédance réglable.

L'invention concerne également l'application des dispositions précédentes pour réaliser un circuit de réception intégré comportant au moins un récepteur prévu pour être relié par une liaison de transmission et comportant une impédance d'adaptation reliée à cette ligne. Dans ce cas, chaque impédance d'adaptation est constituée d'une impédance intégrée réglable et réglée par l'asservissement dont l'impédance de référence calibrée a une valeur égale à l'impédance caractéristique de la ligne.

L'invention concerne enfin un système informatique dans lequel l'interconnexion entre les unités fonctionnelles de ce système est réalisée au moyen de circuits de réception intégrés tels que définis précédemment et associés respectivement aux unités de ce système. Chaque récepteur du circuit de réception est alors relié par une liaison de transmission à un émetteur d'une autre unité fonctionnelle du système.

D'autres aspects, détails de réalisation et avantages du circuit intégré selon l'invention sont également exposés dans la description qui va suivre.

- La figure 1 représente un amplificateur bidirectionnel pouvant faire partie d'un circuit intégré selon l'invention.

- La figure 2 représente des premiers moyens d'asservissement associés à l'amplificateur bidirectionnel.

- La figure 3 représente un amplificateur bidirectionnel de type différentiel.

- La figure 4 représente une réalisation des premiers moyens d'asservissement.

- La figure 5 représente la partie réception de l'émetteur-récepteur.

- La figure 6 représente des moyens d'asservissement des impédances réglables.

- La figure 7 représente un mode de réalisation d'une impédance réglable.

- La figure 8 représente des circuits permettant de réaliser les moyens d'asservissement des impédances réglables.

- La figure 9 représente un circuit d'interfaces parallèle-série, série-parallèle pouvant faire partie d'un circuit intégré selon l'invention et utilisable pour réaliser l'interconnexion entre les unités d'un système informatique.

- Les figures 10, 11 et 12 illustrent les procédés de test applicables aux circuits intégrés selon l'invention.

L'amplificateur 1 comprend une impédance d'adaptation R reliée à la ligne L par des. bornes B ainsi qu'un premier générateur de courant G1 commandé par un signal de commande d'émission e. Le générateur G1 est branché en parallèle avec un montage comportant une seconde impédance r branchée en série avec un second générateur de courant G2 de même polarité que le générateur G1 et commandé par le signal e* complément de e. La borne V de l'impédance r qui est reliée au générateur de courant G2 constitue la borne de réception dont la tension est représentative du signal émis par l'autre station reliée à l'autre extrémité de la ligne L. L'autre borne U de l'impédance r est reliée au point commun à l'impédance R, au générateur G1 et à la ligne L.

L'autre borne de l'impédance R est reliée à un potentiel fixe Vdd supposé être la masse du circuit. Dans le cas où la ligne est un câble coaxial, comme représenté, le blindage du câble est relié à la masse.

Le premier générateur de courant G1 est constitué d'une première source de courant S1 fournissant un courant I d'intensité variable en fonction d'un signal de réglage AI. La source de courant S1 est reliée à l'impédance R par l'intermédiaire d'un interrupteur T1 commandé par le signal e.

De façon analogue, le second générateur G2 comporte une seconde source de courant S2 fournissant un courant i réglé en fonction d'une tension de référence Vref et reliée à l'impédance r par l'intermédiaire d'un second interrupteur T2 commandé par le signal e*.

Les sources de courant S1, S2 sont alimentées par un second potentiel fixe Vss négatif par rapport à la masse. L'impédance R est supposée variable en fonction de signaux de réglage AR par l'intermédiaire d'un décodeur 8.

Pour simplifier les explications du principe de fonctionnement de l'amplificateur bidirectionnel, nous supposerons tout d'abord que la ligne L est sans perte, que i est négligeable par rapport à I et que la valeur de l'impédance R est très petite par rapport à celle de r. D'autre part, nous supposerons qu'un amplificateur bidirectionnel de même constitution d'une station éloignée est connecté à l'autre extrémité de la ligne L. Enfin, nous supposerons que l'état d'émission d'une station se traduit par la mise à 1 logique du signal de commande d'émission e qui, dans ce cas, provoque la fermeture de l'interrupteur T1 et l'ouverture de l'interrupteur T2.

En fonctionnement, quatre situations peuvent se présenter:

a) La station considérée est seule à émettre. Le générateur G2 est alors inactif tandis que le générateur G1 fournit un courant I à l'impédance R en parallèle avec l'impédance caractéristique de la ligne L. L'impédance R étant supposée adaptée à la ligne, un courant I/2 circule dans cette impédance et la tension présente à la borne U ainsi qu'à la borne V est égale à - R.I/2.

b) Si aucune station n'émet, le générateur G1 de chaque station est inactif, les générateurs G2 sont actifs. La tension à la borne V est alors pratiquement égale à - r.i.

c) Si les deux stations émettent, les générateurs G2 sont inactifs et le courant I produit par le premier générateur G1 de la station et celui de la station éloignée se superposent dans les impédances R et dans la ligne. En supposant un fonctionnement linéaire, la tension présente àla borne U ainsi qu'à la borne V est donc égale à - R.I.

d) Si la station éloignée est seule à émettre, un courant I/2 circule dans l'impédance R et la tension présente à la borne U est égale à - R.I/2. D'autre part, le courant i circule dans l'impédance r et la tension à la borne V est donc égale a - r.i - R.I/2.

Le but étant d'obtenir un signal ne dépendant que de l'état d'émission de la station éloignée, on constate que si l'on choisit les valeurs des impédances r et R et des courants i et I telles que l'on ait la relation : r.i = R.I/2, la tension de la borne de réception V vérifie bien cette condition. Cette tension sera donc égale à - R.I lorsque la station éloignée émet et à -R.I/2 lorsqu'elle n'émet pas.

Il convient cependant de remarquer que la relation r.i = R.I/2 permet d'obtenir des niveaux de tension sur la borne V strictement indépendants de l'état d'émission de la station à condition que les hypothèses initiales soient parfaitement vérifiées. Dans le cas contraire, la tension à la borne de réception V dépendrait de l'état d'émission mais la compensation imparfaite qui en résulterait pourrait, dans certaines conditions, permettre tout de même de détecter l'émission de la station éloignée en comparant la tension de réception à des valeurs de seuil bien choisies.

Un calcul plus précis permettrait d'établir une relation entre R, I, r, i pour réaliser exactement la compensation dans le cas réel. Cette relation doit exprimer la condition que la chute de tension dans les impédances R et r en série observée lorsque l'émetteur considéré est seul à émettre est égale à celle observée quand aucun émetteur n'émet. Cette condition est rigoureuse en fonctionnement linéaire et reste valable sans qu'il soit nécessaire de faire des hypothèses sur l'ordre de grandeur de la résistance r ou du courant i, ni sur l'impédance caractéristique de la ligne.

Ainsi, en supposant un fonctionnement idéal des générateurs de courant, la condition de compensation s'exprime par la relation : R.I/2 = (R/2 + r). i

La condition de compensation pourrait être satisfaite grâce à un dimensionnement approprié des résistances et des sources de courant de l'émetteur-récepteur. Cependant, dans la perspective d'une réalisation intégrée, il faut prévoir des moyens permettant d'ajuster automatiquement les caractéristiques des composants et des circuits de façon à compenser les dispersions de fabrication et les dérives de caractéristiques.

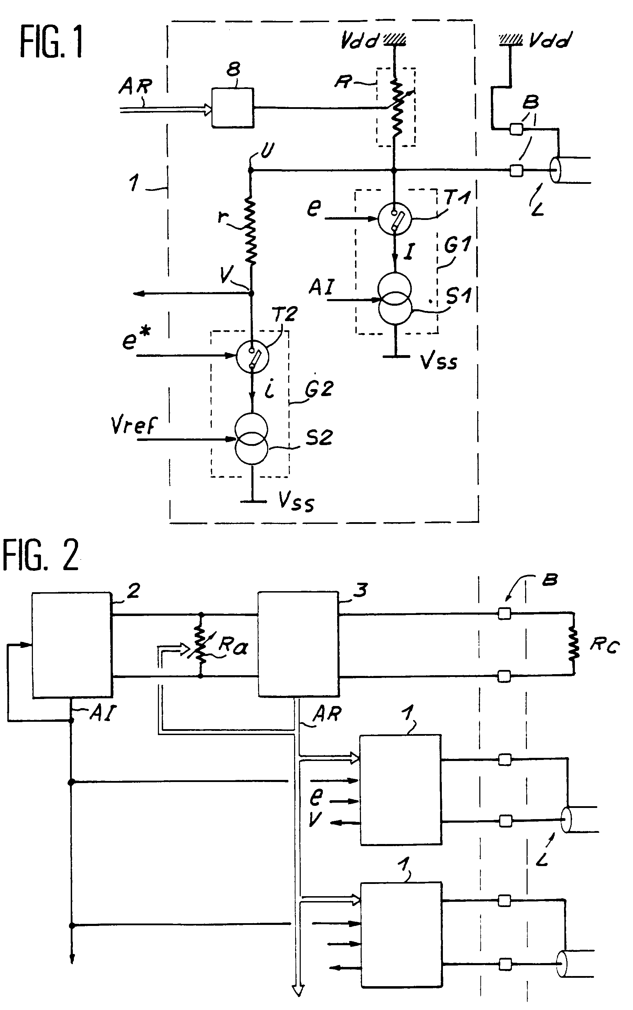

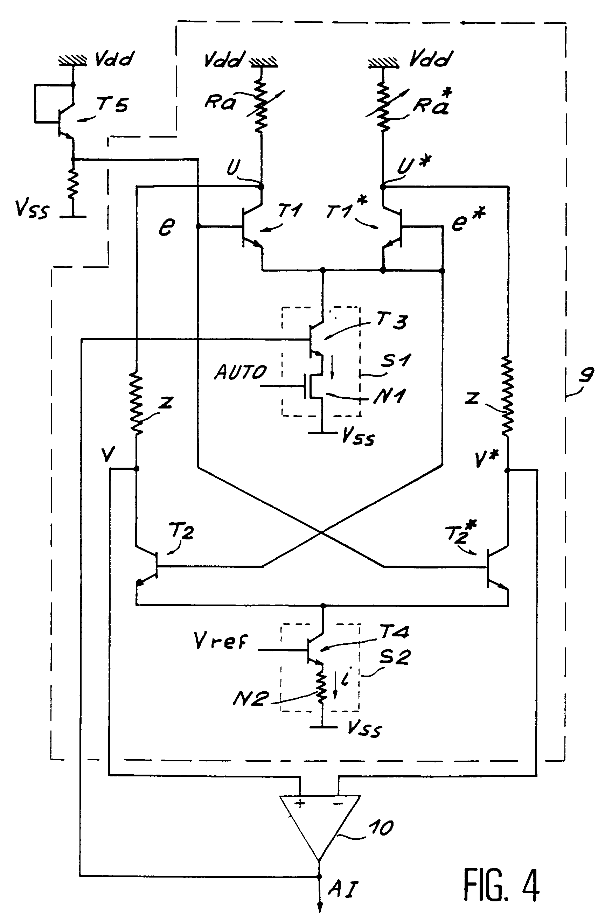

Dans ce but, on prévoit des moyens d'asservissement représentés schématiquement à la figure 2. Cette figure représente un circuit intégré comportant plusieurs émetteurs-récepteurs dont seuls les amplificateurs bidirectionnels 1 sont représentés. Chaque amplificateur 1 est relié à une ligne associée L par l'intermédiaire des plots B du circuit intégré. Le circuit comporte des moyens d'asservissement des courants I et des impédances d'adaptation R des amplificateurs 1. L'asservissement de I est effectué au moyen d'un circuit de commande de courant 2 relié à une impédance d'asservissement Ra de constitution et de dimensionnement fonction des impédances R. Le circuit 2 fournit un signal AI de réglage de courant appliqué à l'entrée de réglage des sources de courant S1 des amplificateurs 1. Le circuit 2 est conçu de façon à régler le courant I des sources de courant pour vérifier la condition de compensation évoquée précédemment. La description détaillée du circuit 2 sera donnée en relation à la figure 4.

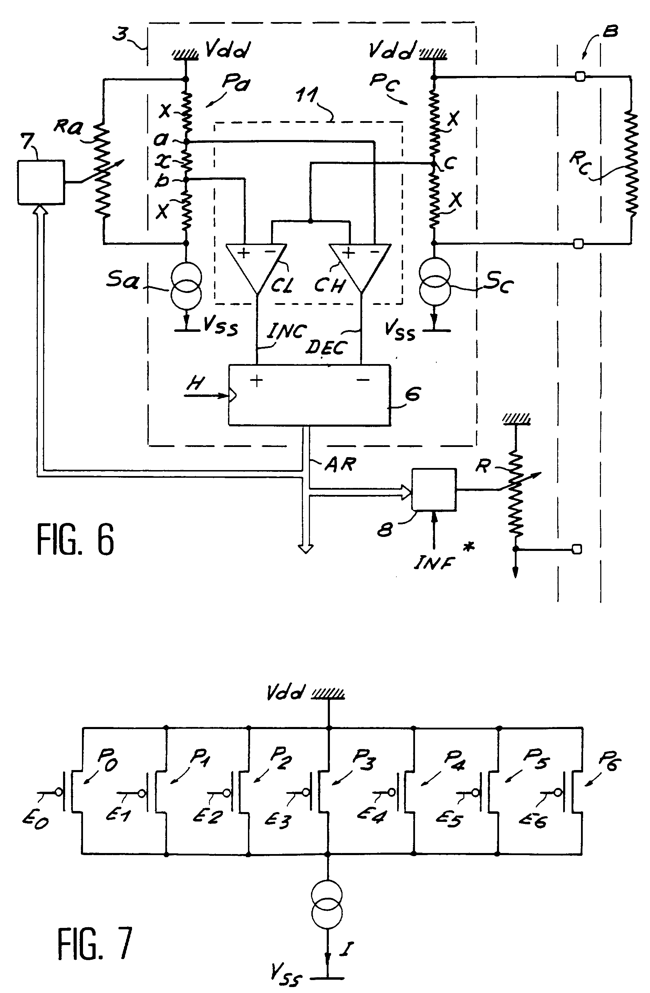

Les moyens d'asservissement des impédances R comportent un circuit de commande de résistance 3 relié à l'impédance d'asservissement Ra et à une impédance calibrée Rc extérieure au circuit intégré. Le circuit 3 fournit un signal de réglage AR de l'impédance d'asservissement Ra et des impédances R des amplificateurs. Le circuit 3 asservit la valeur des résistances Ra et R à la valeur de la résistance calibrée Rc égale à l'impédance caractéristique des lignes L. Le circuit 3 sera décrit en détail en référence à la figure 6.

Les moyens d'asservissement de l'intensité I et des impédances R assurent que la condition de compensation sera vérifiée quelles que soient les dispersions de fabrication et les dérives de caractéristiques tout en maintenant la condition d'adaptation des impédances d'adaptation.

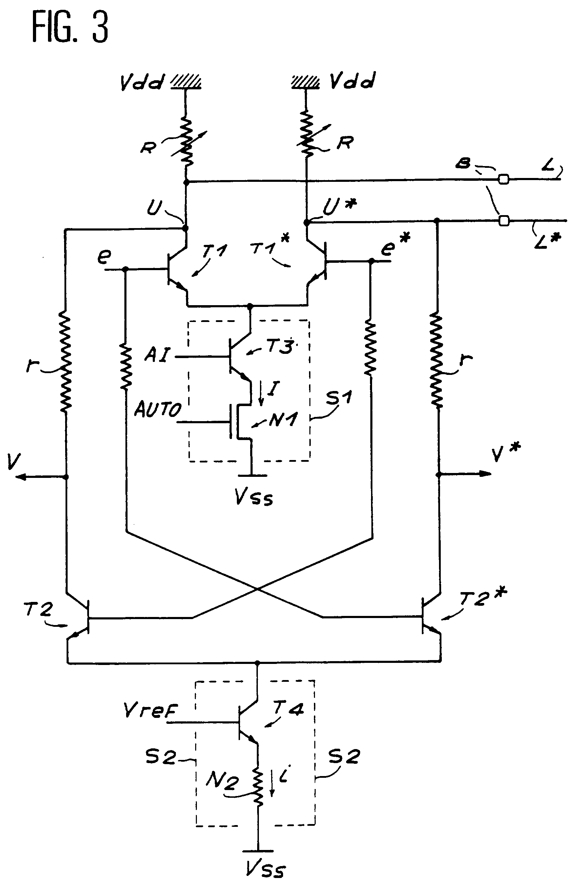

La figure 3 représente une réalisation en technologie BiCMOS d'un amplificateur bidirectionnel de type différentiel. Il est fonctionnellement équivalent à deux amplificateurs bidirectionnels conformes à la figure 1, disposés symétriquement et reliés respectivement aux lignes L, L* d'une liaison différentielle. Comme en mode différentiel une seule des voies est active à la fois, il suffit de prévoir une seule source de courant S1, S2 commune aux générateurs de courant G1, G2, associés aux deux voies.

Ainsi, la voie de gauche associée à la ligne L comporte une impédance d'adaptation R reliée par le point U à la ligne L et au collecteur d'un transistor bipolaire T1 dont l'émetteur est relié à la première source de courant commune S1. La base du transistor T1 reçoit le signal de commande d'émission e. Le collecteur du transistor T1 est relié au collecteur V d'un second transistor T2 par l'intermédiaire de l'impédance r. L'émetteur du transistor T2 est relié à la seconde source de courant commune S2. Symétriquement, la voie de droite reliée à la seconde ligne L* de la liaison différentielle comporte une impédance d'adaptation R reliée par le point U* au collecteur d'un transistor T1* dont l'émetteur est relié à la source de courant commune S1. Le collecteur du transistor T1* est relié au collecteur V* du transistor T2* par l'intermédiaire de l'impédance r. L'émetteur du transistor T2* est relié à la seconde source de courant commune S2. Le transistor T1* reçoit sur sa base le signal e* complément du signal e. Les signaux e et e* constituent des signaux différentiels de commande d'émission. Ces signaux sont complémentaires et représentatifs d'une valeur logique déterminée. Les signaux e et e* sont appliqués respectivement sur la base des transistors T2* et T2, par l'intermédiaire de résistances servant à compenser la constante de temps due à la capacité de structure des impédances R.

La source de courant S1 est constituée d'un transistor bipolaire T3 dont le collecteur est relié aux émetteurs des transistors T1 et T1* et dont l'émetteur est relié au potentiel négatif Vss par l'intermédiaire du chemin drain-source d'un transistor NMOS N1. La base du transistor T3 est commandée par le signal de réglage AI et la grille du transistor N1 reçoit le signal de commande d'alimentation AUTO. De façon analogue, la seconde source de courant S2 est constituée d'un transistor bipolaire T4 dont le collecteur est relié aux émetteurs des transistors T2 et T2* et dont l'émetteur est relié à la tension Vss par l'intermédiaire d'une résistance N2.

Le fonctionnement du circuit de la figure 3 se déduit facilement de celui de la figure 1 grâce aux remarques suivantes. Pour chaque voie, le premier générateur de courant G1 est constitué du transistor T1 ou T1* faisant fonction d'interrupteur et de la première source de courant commune S1. De même, le second générateur de courant G2 est formé du transistor T2 ou T2* et de la seconde source de courant S2. Chaque voie fonctionne alors exactement comme le circuit de la figure 1 mais, compte tenu du mode de fonctionnement différentiel, un seul des signaux de commande d'émission e, e* est actif à la fois, aussi bien pour l'émetteur-récepteur de la station considérée que pour celui de la station éloignée. Il en résulte que, grâce à la compensation décrite précédemment, les tensions présentes aux bornes de mesure V et V* prendront respectivement les valeurs - RI et -RI/2 ou -RI/2 et - RI selon que la voie de gauche ou la voie de droite de l'émetteur de la station éloignée est active ou non. Les tensions V et V* constituent donc un signal différentiel fonction du signal différentiel d'émission de la station éloignée et pourra être exploité en aval de l'amplificateur après une mise en forme appropriée.

La figure 4 représente un circuit de commande de courant 2 particulièrement adapté pour commander l'amplificateur différentiel de la figure 3. Nous avons vu que la condition de compensation impose que la chute de tension dans les résistances R et r en série doit être la même lorsque l'émetteur considéré est seul à émettre et lorsqu'aucun émetteur n'émet. Par conséquent, le circuit de la figure 4 est conçu de façon à simuler ces deux cas, à comparer les tensions de mesure correspondantes et à régler le courant I de façon à obtenir l'égalité de ces tensions.

Dans ce but, le circuit de la figure 4 comporte un circuit d'asservissement 9 de même constitution et de même dimensionnement pour l'essentiel que l'amplificateur différentiel de la figure 3 mais modifié de façon à réaliser sur ses deux voies les simulations recherchées. En particulier, un signal de commande d'émission différentiel fixe est appliqué aux bases des transistors T1, T1* de façon à les rendre respectivement conducteur et non-conducteur. Pour cela, l'émetteur du transistor T1* est relié à sa base tandis que la base du transistor T1 reçoit une tension positive par rapport à Vss. Cette tension est fournie par un montage comportant un transistor bipolaire T5 dont la base et le collecteur sont reliés à la masse et dont l'émetteur est relié au potentiel Vss par une résistance appropriée. L'émetteur du transistor T5 fournit la tension de base du transistor T1.

D'autre part, l'impédance d'adaptation R et la seconde impédance r sont remplacées respectivement par une impédance d'asservissement Ra, Ra* et une impédance z. Le choix des valeurs de Ra, Ra* et z doit tenir compte du fait que, contrairement au circuit 9, l'émetteur-récepteur a ses impédances d'adaptation R reliées aux lignes et que par conséquent la source de courant S1 alimente une impédance équivalente égale à la moitié de l'impédance d'adaptation. Ainsi, selon une première possibilité, les impédances d'asservissement Ra, Ra* pourraient être réalisées en plaçant en parallèle deux impédances identiques aux impédances d'adaptation R utilisées dans l'émetteur-récepteur. Dans ce cas, l'impédance z serait identique à r.

Selon une autre possibilité, on utilise des impédances d'asservissement Ra, Ra* identiques à l'impédance d'adaptation R, en choisissant pour z une valeur égale au double de celle de la seconde impédance r. L'impédance r sera alors réalisée par la mise en parallèle de deux impédances identiques à z. Cette solution simplifie la réalisation des impédances d'asservissement Ra, Ra* qui, comme les impédances d'adaptation R, sont de préférence réglables. De plus, cette solution permet d'utiliser l' impédance Ra de la voie de gauche pour réaliser l'asservissement des impédances R, comme nous le verrons plus loin.

Selon encore une autre possibilité, les impédances R et Ra d'une part, r et z d'autre part ont la même valeur mais le courant fourni par la source de courant S1 du circuit d'asservissement 9 est moitié de celui fourni par la source S1 de l'amplificateur bidirectionnel. Pour cela, il suffit de dimensionner le transistor N1 du circuit 9 pour qu'il ait une résistance double de celui de l'amplificateur. Dans la mesure où R n'est pas négligeable par rapport à r, il conviendrait que Ra* soit égale à R/2.

Dans tous les cas, toujours en supposant un fonctionnement linéaire, les tensions V et V* sont proportionnelles aux chutes de tension aux bornes des impédances R et r de l'émetteur respectivement lorsqu'il est seul à émettre et lorsqu'aucun émetteur n'émet. Les tensions V et V* sont appliquées respectivement à l'entrée directe et inverseuse d'un amplificateur différentiel 10 à grand gain et forte impédance d'entrée dont la sortie fournit le signal de réglage de courant AI qui est ensuite appliqué à la base des transistors T3 des sources de courant S1 du circuit d'asservissement 9 et des amplificateurs bidirectionnels 1.

Selon une variante de réalisation, l'amplificateur 10 pourrait être remplacé par un montage numérique analogue à celui utilisé pour l'asservissement des impédances comme nous le verrons en détail ultérieurement.

De façon évidente, le circuit de la figure 4 règle le courant I des sources de courant S1 de façon à maintenir en permanence la condition de compensation recherchée.

Le circuit d'asservissement 9 étant pour l'essentiel de même constitution et dimensionnement que les amplificateurs bidirectionnels 1, il reproduit avec une bonne précision leur comportement indépendamment des dispersions de fabrication et tient compte des courants de fuite éventuellement non négligeables des transistors de commutation T1, T1*, T2, T2*.

Bien entendu, ce circuit assure que la condition de compensation sera strictement vérifiée du point de vue statique, ce qui est suffisant en général car l'impédance caractéristique de la ligne, donc les impédances R et r, sont, pour des fréquences élevées, pratiquement des résistances pures. L'homme du métier pourra bien sûr adapter cette réalisation pour mieux tenir compte des caractéristiques réelles de la ligne dans chaque cas particulier.

Selon un aspect intéressant de la réalisation de l'amplificateur bidirectionnel et du circuit d'asservissement, ces derniers comportent une seconde source de courant S2 identique formée du transistor T4 en série avec une résistance N2. Il en résulte que la tension Vref appliquée à la base du transistor T4 fixe la chute de tension dans la résistance N2 et par conséquent le courant i qui la traverse. Ainsi, compte tenu de la condition de dimensionnement imposée par le circuit d'asservissement, le choix de la tension Vref détermine indirectement le produit R.I qui doit être fixé avec précision car il fixe la dynamique des signaux.

Dans le cadre d'une application à un circuit d'interface parallèle-série, série-parallèle pour réaliser l'interconnexion d'un grand nombre d'unités, il est intéressant de prévoir la possibilité de couper l'alimentation des circuits de puissance des émetteurs et récepteurs inactifs. C'est pourquoi les sources de courant S1 sont munies d'un transistor NMOS N1 commandé par un signal de mise sous tension AUTO. Cette disposition présente l'avantage, notamment dans le cas d'une réalisation intégrée, de réduire la consommation du circuit d'interface.

Il convient cependant de tenir compte de cette possibilité dans la conception de la partie réception de l'émetteur-récepteur. En effet, si l'émetteur-récepteur de la station éloignée est à l'état de repos, c'est-à-dire a sa source de courant S1 inactive, aucune des lignes différentielles n'est alimentée par cet émetteur-récepteur. Il en résulte qu'aucune tension différentielle V, V* n'apparaît en sortie de l'amplificateur bidirectionnel, ce qui pourrait provoquer une détection erronée des signaux de réception. Pour éviter cette difficulté, il est prévu un ensemble de moyens dans la partie réception de l'émetteur-récepteur pour traiter ce cas.

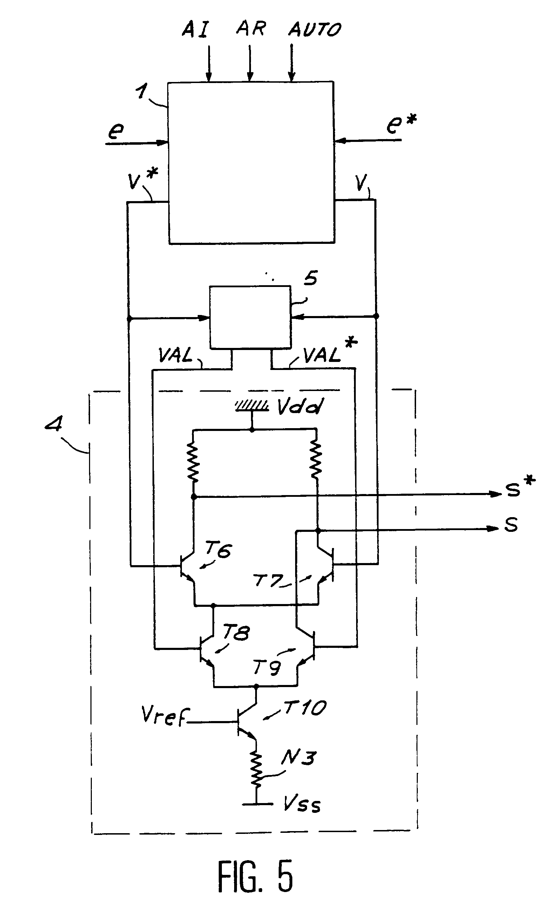

La figure 5 représente la partie réception dans son ensemble. On retrouve évidemment l'amplificateur bidirectionnel 1 qui est associé à un circuit de mise en forme 4 et à un circuit de détection d'activité de ligne 5. Le circuit 5 reçoit les tensions V, V* de l'amplificateur 1 et fournit un signal différentiel VAL, VAL* résultant de la comparaison entre la tension différentielle V, V* et une valeur de seuil déterminée. Le circuit 5 est constitué en fait d'un ensemble de comparateurs pour comparer respectivement les tensions V et V* à une valeur de seuil comprise entre les tensions maximales et minimales pouvant être prises par V et V* lorsque la station éloignée est active. Si l'une des tensions V ou V* est supérieure à ce seuil en valeur absolue, un circuit logique place respectivement à un niveau haut et bas les sorties VAL et VAL* du circuit 5. Dans le cas contraire, les signaux VAL et VAL* sont placés respectivement à des niveaux bas et haut. La réalisation du circuit 5 étant à la portée de l'homme du métier, nous n'en donnerons pas une description plus détaillée.

Le circuit de mise en forme 4 est une porte ET en technologie ECL composée de deux transistors T6, T7 reliés entre eux par leur émetteur et dont les collecteurs sont reliés chacun à la masse par l'intermédiaire d'une résistance. Deux autres transistors T8, T9 ont leur émetteur relié au collecteur d'un cinquième transistor T10 dont l'émetteur est relié à la tension Vss par l'intermédiaire d'une résistance N3. Le collecteur du transistor T8 est relié aux émetteurs des transistors T6 et T7 tandis que le collecteur du transistor T9 est relié au collecteur du transistor T7. La base du transistor T10 reçoit la tension de référence Vref de façon à fixer le courant circulant dans la résistance N3. Les bases des transistors T6 et T7 reçoivent respectivement les tensions V* et V. Les bases des transistors T8 et T9 reçoivent respectivement les signaux d'activité de ligne VAL et VAL*. Les tensions s* et s des collecteurs des transistors T6 et T7 constituent les signaux de réception différentiels utilisables en aval dans le reste du circuit.

Le circuit de la figure 5 fonctionne de la façon suivante. Si la station éloignée est active, il existe une tension différentielle V, V* qui est détectée par le circuit 5 fournissant alors un signal différentiel positif VAL, VAL*. Il en résulte que le transistor T8 est conducteur et que le transistor T9 est bloqué. Le circuit 4 fonctionne alors en amplificateur différentiel produisant sur ses sorties s, s* un signal différentiel fonction de la tension différentielle V, V*.

Si par contre le circuit 5 détecte l'inactivité de la station éloignée, les signaux VAL et VAL* prennent des valeurs complémentaires du cas précédent. Le transistor T8 est alors bloqué et le transistor T9 est conducteur. Il en résulte que le signal s est à l'état bas et le signal s* est à l'état haut, forçant ainsi la sortie différentielle du circuit de mise en forme à la valeur 0 logique.

La description qui précède montre l'intérêt de fixer avec assez de précision la valeur du produit R.I de façon à permettre un bon fonctionnement des comparateurs du circuit de détection 5.

La figure 6 représente les moyens d'asservissement des impédances d'adaptation R. Ils comprennent un comparateur d'impédance 3 relié à une impédance de référence Rc et à une impédance d'asservissement Ra. L'impédance de référence Rc est une impédance calibrée extérieure au circuit intégré et l'impédance Ra est une impédance intégrée réglable de mêmes constitution et dimensionnement que les impédances d'adaptation R à régler.

Le comparateur d'impédance 3 délivre un signal de réglage numérique AR relié aux décodeurs 7, 8 associés respectivement à l'impédance Ra et à chaque impédance d'adaptation R. Chaque décodeur 7, 8 commande la valeur de l'impédance associée. Les décodeurs 8 associés aux impédances d'adaptation R se distinguent du décodeur 7 de l'impédance Ra par la présence d'une entrée supplémentaire INF* prévue pour les opérations de test qui seront expliquées ultérieurement.

Comme pour l'asservissement du courant, la réalisation décrite ci-dessous permet d'ajuster la partie purement résistive des impédances d'adaptation. L'homme du métier pourra modifier cette réalisation pour tenir compte, si nécessaire, des caractéristiques réelles de la ligne.

Le comparateur d'impédance 3 comprend deux ponts diviseurs de tension Pa, Pc branchés en parallèle respectivement avec Ra et Rc. Ces deux montages parallèles sont alimentés respectivement par les sources de courant Sa et Sc identiques. Dans le cas où l'impédance Ra est celle utilisée dans le circuit 9 d'asservissement des courants, la source Sa est en fait la source S1 du circuit 9. Le comparateur 3 comporte également un comparateur de tension 11 relié aux ponts diviseurs Pa et Pc ainsi qu'un compteur-décompteur 6. Le comparateur de tension 11 est en fait constitué de deux comparateurs CL, CH fournissant respectivement un signal INC d'incrémentation appliqué à l'entrée de comptage du compteur-décompteur 6 et un signal de décrémentation DEC appliqué à son entrée de décomptage. Le point milieu c du pont diviseur Pc de résistance 2X est relié à l'entrée inverseuse du comparateur CL et à l'entrée directe du comparateur CH. Le pont diviseur Pa comporte deux bornes intermédiaires a, b telles que la résistance X entre le point a et la masse et la résistance entre le point b et la source de courant Sa soient égales, une résistance x entre les points a et b étant égale à une fraction de X. Le point a est relié à l'entrée inverseuse du comparateur CH et le point b est relié à l'entrée directe du comparateur CL. Cette disposition permet par un dimensionnement approprié de X et x de produire un effet d'hystérésis tel que les signaux d'incrémentation INC ou de décrémentation DEC soient actifs lorsque la valeur de l'impédance d'asservissement Ra est respectivement inférieure ou supérieure à la valeur de l'impédance de référence Rc d'une valeur de seuil déterminée. Ceci présente l'avantage d'éviter une instabilité dans la régulation des impédances d'adaptation.

Cette valeur de seuil sera définie par un pourcentage d'erreur imposé et portant sur la valeur de Rc. On peut constater d'autre part que le fonctionnement du comparateur 3 est pratiquement indépendant des dispersions de fabrication, dans la mesure où X est suffisamment grand par rapport à Rc, ce qui est toujours possible.

Ainsi, l'état du compteur-décompteur 6 est représentatif de la valeur de réglage à appliquer aux impédances R et Ra pour que leur valeur soit égale à la valeur de l'impédance de référence Rc à un pourcentage d'erreur près.

L'asservissement de la figure 6 est donc du type à commande numérique. On aurait pu imaginer une solution analogique utilisant par exemple des transistors PMOS, les résistances des chemins drain-source constituant les impédances réglables R et Ra, les grilles étant commandées par un signal de réglage analogique représentatif de la différence entre la valeur de l'impédance calibrée Rc et celle de l'impédance d'asservissement Ra. Or, cette solution présente l'inconvénient que le signal de réglage analogique est exposé à des altérations lors de sa transmission dans le circuit, en particulier dans le cas d'un circuit intégré comportant un grand nombre d'émetteurs-récepteurs.

La réalisation numérique de la figure 6 résout donc ce problème. L'utilisation, suggérée ci-dessus, de transistors PMOS comme impédances réglables serait possible en leur associant des circuits de conversion numérique-analogique. Cependant, cette solution nécessiterait d'utiliser des transistors volumineux dont la capacité de structure pourrait perturber le fonctionnement à très haute fréquence.

Une solution entièrement numérique est donc préférable. Pour cela, chaque impédance variable est réalisée au moyen d'une pluralité de résistances branchées sélectivement en parallèle par un signal de réglage numérique. On peut noter que le cas de l'impédance Ra est légèrement différent de celui des impédances R car il n'est pas nécessaire de prévoir la possibilité pour Ra de prendre une valeur infinie pour les opérations de test. Par conséquent, l'une des résistances de Ra pourra être branchée en permanence.

La figure 7 représente une telle réalisation où chaque résistance est constituée d'un transistor PMOS P0-P6. Les transistors sont branchés en parallèle, leurs sources étant reliées à la masse et leurs drains à la source de courant associée. Les grilles des transistors P0-P6 sont commandées respectivement par les signaux E0-E6. La résistance du chemin drain-source de chaque transistor prend alors une valeur qui dépend du dimensionnement du transistor (sa largeur de grille par exemple) ainsi que du procédé de fabrication, avec une incertitude autour d'une valeur typique correspondant au cas le plus probable.

On pourrait imaginer de choisir un dimensionnement des résistances P0-P6 de façon à réaliser une pondération d'un code binaire (les résistances sont toutes différentes et proportionnelles à une puissance de 2) mais cette réalisation pose le problème des commutations simultanées de plusieurs résistances qui pourraient provoquer des perturbations au niveau des lignes.

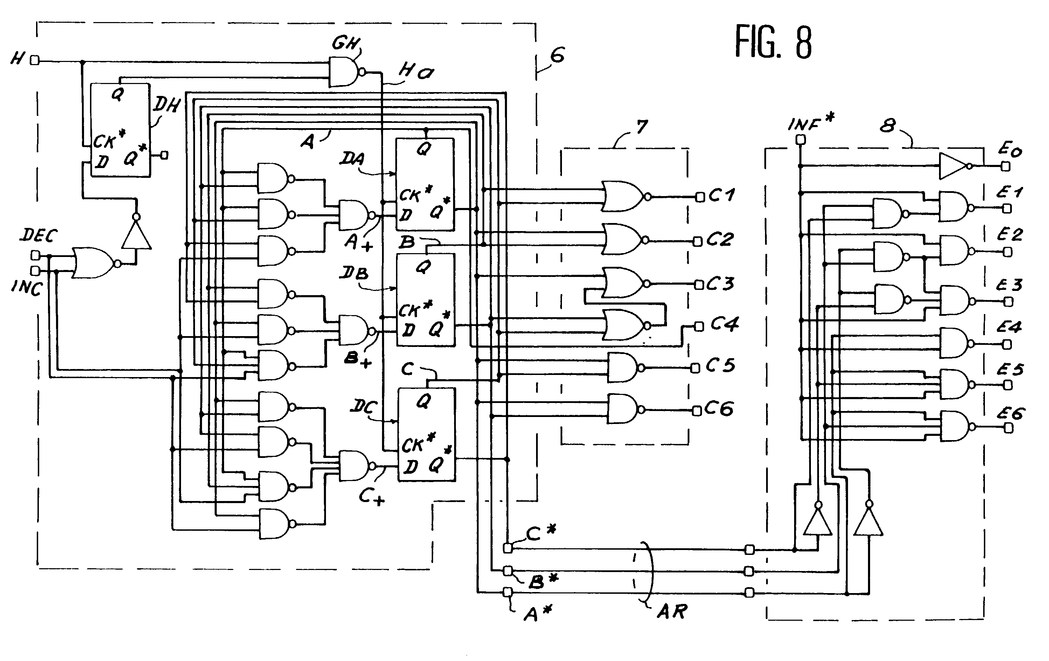

Pour éviter ce problème, il est préférable d'utiliser des résistances dimensionnées de façon à ce que leurs activations successives conduisent à des valeurs régulièrement décroissantes de la résistance équivalente en résultant. En contrepartie, ceci entraîne, pour une précision donnée, une augmentation du nombre de résistances et donc du nombre de signaux de commande. Aussi, pour compenser cet inconvénient, la solution choisie consiste à utiliser comme signal de réglage AR un signal de réglage numérique codé et à associer à chaque impédance à régler un décodeur 7, 8 correspondant. Le code utilisé est avantageusement un code de Gray fourni directement par le compteur-décompteur 6. Une réalisation détaillée de ce compteur-décompteur et des décodeurs associés est représentée à la figure 8.

Avant de décrire la figure 8, il convient de donner un exemple de réalisation détaillée des circuits précédents.

L'impédance caractéristique de la ligne étant de 50 ohms, on impose par exemple une erreur de moins de 5 % sur les impédances d'adaptation, dans les limites d'une dispersion d'environ 25 % sur les valeurs des composants.

Les impédances d'adaptation doivent alors pouvoir varier régulièrement entre 37 et 63 ohms environ dans le cas typique. Les calculs et les simulations conduisent alors à une solution à 7 transistors PO à P6 de résistances croissantes dont les dimensionnements sont faciles à calculer en fonction de la technologie employée.

D'autre part, les signaux d'incrémentation INC ou de décrémentation DEC doivent s'activer lorsque l'impédance Ra est respectivement inférieure ou supérieure de 5 % à l'impédance Rc. Les calculs montrent alors, avec Rc = 50 ohms, que l'on peut prendre X = 500 ohms et x = 50 ohms. En prenant R.I. = O,5 V, il en résulte une immunité au bruit pour un niveau de bruit inférieur à 3,3 mV.

La figure 8 représente le compteur-décompteur 6 et les décodeurs 7 et 8 dans le cas particulier où les impédances d'adaptation comportent 7 transistors PMOS en parallèle.

Le décodeur 7 associé à Ra possède seulement 6 sorties C1 àC6 reliées respectivement aux grilles des transistors P1 à P6. Le transistor P0 est rendu conducteur en permanence par une polarisation négative de sa grille. Lorsqu'une sortie C1-C6 du décodeur 7 prend la valeur 0 logique, le transistor qu'elle commande P1-P6 est rendu conducteur.

Le décodeur 8 comporte 7 sorties E0 à E6 et a un fonctionnement analogue au décodeur 7 à la différence près que le premier transistor P0 peut être conducteur ou bloqué selon que la sortie E0 est à 0 ou à 1.

Le compteur-décompteur 6 comprend trois bascules DA, DB, DC de type D définissant l'état du compteur. Les bascules DA, DB, DC reçoivent respectivement sur leurs entrées D les signaux logiques $A_+$, $B_+$, $C_+$ fournis par un ensemble de portes logiques en fonction des signaux INC et DEC et des états A, B, C des bascules DA, DB, DC.

Ce circuit logique effectue les équations suivantes :

$$(1) \quad A_+ = [(A.B^*) * .(A.C) * . (C^*.INC)^*]^*$$

$$(2) \quad B_+ = [(B.C^*) *.(A^*.INC)^*.(A.C.DEC)^*]^*$$

$$(3) C_+ = [(A^*.B^*) *. (A^*.DEC) *.(B^*.DEC) *. (A.B.INC) *]*$$

où le symbole * indique l'opération de complémentation.

Grâce à cette logique de commande, le compteur peut prendre sept états différents, l'état 000 étant interdit. Chaque état A, B, C correspond à la valeur codée en code de Gray du nombre de transistors qui doivent être à l'état conducteur. Cette disposition implique que toute modification imposée à la valeur des impédances à régler se traduit par le changement d'état d'une seule des bascules DA, DB, DC à la fois.

Afin d'améliorer la sécurité de fonctionnement du compteur-décompteur, les bascules sont synchronisées par les fronts descendants d'un signal d'horloge Ho fonction d'un signal primaire H et de l'état d'une bascule supplémentaire DH. La bascule DH reçoit sur son entrée d'horloge inverse CK* le signal d'horloge H et sur son entrée D la somme logique DEC+INC. Le signal d'horloge H et la sortie non inverseuse Q de la bascule DH sont reliés aux entrées d'une porte NON-ET (NAND) GH délivrant le signal Ho aux entrées d'horloge inverses CK* des bascules DA, DB, DC.

Le compteur-décompteur 6 fonctionne de la façon suivante. Lorsque l'écart en valeur absolue entre les valeurs de Ra et de Rc est inférieur au seuil, les signaux DEC et INC restent à 0. Lors d'un front descendant du signal d'horloge H, la bascule DH est mise à 0 et la sortie Ho de la porte GH est maintenue à 1, ce qui interdit tout changement d'état des bascules DA, DB, DC. Si par contre l'écart entre Ra et Rc dépasse le seuil, l'un des signaux DEC ou INC est à 1 et l'entrée D de la bascule DH reçoit la valeur 1 logique. A l'apparition du front descendant d'horloge suivant, l'état de la bascule DH repasse à 1 et la sortie de la porte GH délivre un signal complémentaire du signal d'horloge H. La sortie de la porte GH est donc à 1 mais repasse à 0 à l'apparition du front montant suivant de H et les bascules DA, DB, DC sont réactualisées conformément aux équations (1), (2), (3) précédentes.

Le fonctionnement qui vient d'être décrit montre que le compteur-décompteur n'est activé que lorsqu'une modification doit avoir lieu et ceci permet de simplifier le circuit logique de commande des bascules. De plus, grâce à la bascule DH et à la porte GH, les bascules DA, DB, DC sont parfaitement synchronisées par l'horloge H sans risque de perturbation par l'apparition des signaux INC ou DEC.

Les décodeurs 7 et 8 reçoivent les signaux d'état A, B, C des bascules DA, DB, DC ou leur complément et fournissent en sortie les signaux C1-C6 ou E0-E6 commandant les impédances variables associées.

Les sorties C1-C6 du décodeur 7 vérifient les équations suivantes :

$$(4) C1 = (B + C)^*$$

C2 = (A* + B)*

C3 = [A* + (B* + C)*]*

C4 = A

C5 = (A* . C)*

C6 = (A*. B*)*

Le décodeur 8 est prévu pour pouvoir commander son impédance à la valeur infinie lorsque le signal de test INF est à 1. D'autre part, pour limiter le nombre de lignes reliant le décompteur-décompteur 6 aux différents décodeurs 8 du circuit intégré, seuls les signaux A*, B*, C* issus des sorties inverseuses des bascules DA, DB, DC sont appliqués à l'entrée du décodeur 8. Compte tenu de ces contraintes, le décodeur 8 est conçu de façon à réaliser les équations logiques suivantes :

(5) E0 = INF

E1* = (B*.C*.INF*)*

E2 = (A.B*.INF*)*

E3 = (A.B*)*. (A.C)*.INF*

E4 = (A* .INF*)*

E5 = (A*.C.INF*)*

E6 = (A*.B*.INF*)*

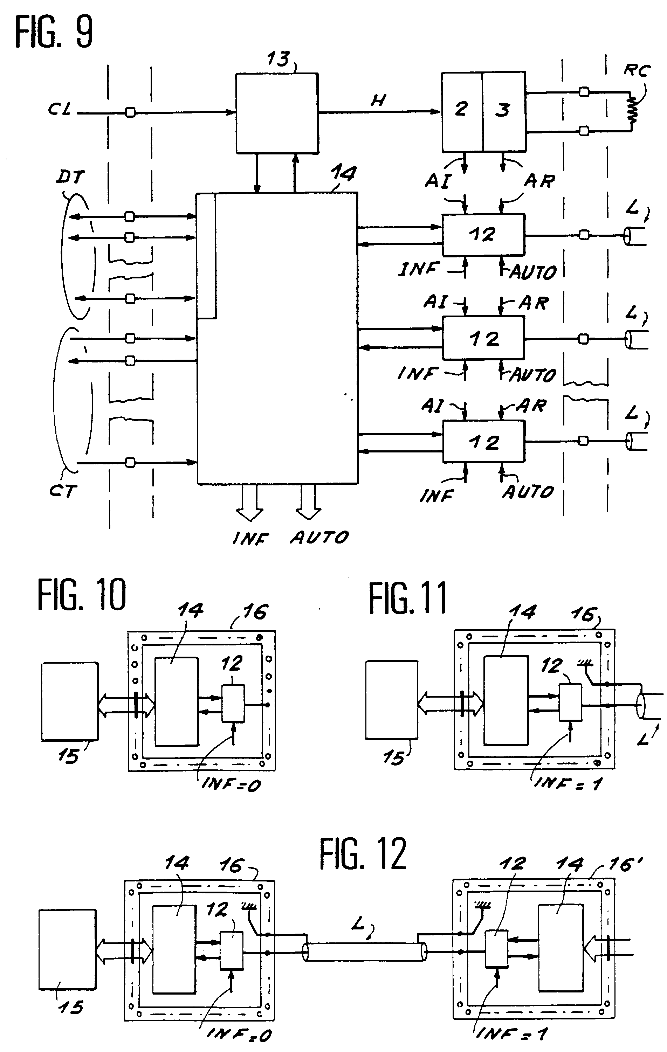

La figure 9 représente un circuit d'interface parallèle-série, série-parallèle dans lequel l'invention peut s'appliquer avantageusement. Ce circuit est supposé être réalisé sous forme de circuit intégré prévu pour être relié d'une part à des lignes d'entrée-sortie parallèles composées de lignes de données DT et de lignes de contrôle CT et d'autre part à des lignes de transmission série L.

Le circuit comprend des moyens de sérialisation-désérialisation 14 reliés aux entrées-sorties parallèles DT, CT ainsi qu'aux divers émetteurs-récepteurs 12 par des lignes d'émission et de réception série associées. Chaque émetteur-récepteur 12 est relié à une ligne de transmission bidirectionnelle L par l'intermédiaire d'un amplificateur 1 conforme à la description précédente. Chaque ligne L relie l'émetteur-récepteur associé à un autre émetteur-récepteur appartenant à une station éloignée.

Le circuit intégré comprend également les moyens d'asservissement 2, 3 du courant I et des impédances d'adaptation R des amplificateurs. Enfin, un générateur d'horloge 13 recevant un signal d'horloge maître CL fourni par une horloge extérieure pilote les moyens de sérialisation-désérialisation 14. En émission, le générateur 13 fonctionne en multiplieur de fréquence de façon à adapter le débit d'émission des données série au débit de réception des données parallèles. En réception, le générateur 13 effectue la régénération d'un signal d'horloge à la fréquence des données série à partir de ces données et effectue une division de fréquence pour contrôler la partie parallèle du sérialiseur-désérialiseur.

Les circuits 13 et 14 font l'objet d'un exemple de réalisation détaillée dans chacune des demandes de brevet français suivantes déposées le 11.07.90 : "Procédé et système de transmission numérique de données en série", n° 90.08811 ; "Dispositif de sérialisation et de désérialisation de données et système de transmission numérique de données en série en résultant", n° 90.08812 ; "Dispositif d'échantillonnage de données et système de transmission numérique de données en résultant", n° 90.08813.

Le circuit 14 comprend en outre des moyens pour sélectionner les émetteurs-récepteurs et leur fournir les signaux INF et AUTO en vue d'effectuer respectivement les opérations de test et la coupure d'alimentation des amplificateurs associés aux lignes inactives.

Le fonctionnement du circuit de la figure 9 est en grande partie classique et ne nécessite donc pas d'explication détaillée. Pour plus de précisions, on pourra se reporter aux demandes de brevet citées ci-dessus.

Il convient cependant de préciser que les moyens de sérialisation-désérialisation 14 comportent des circuits de contrôle de l'activité des émetteurs-récepteurs en fonction de commandes CT indiquant la station destinataire. Réciproquement, ces circuits sont prévus pour délivrer des signaux de contrôle sur l'interface parallèle en réponse à l'identité des lignes actives en réception. D'autre part, on peut prévoir des circuits de décodage fournissant les signaux INF et AUTO aux émetteurs-récepteurs désignés par des commandes CT appropriées. La réalisation pratique de ces circuits dépend essentiellement de l'interface parallèle choisie.

Par exemple, si les commandes CT comportent une partie adresse et une partie contrôle, la partie adresse servira d'entrée à des décodeurs d'adresse. Des signaux de commande de test et de commande d'alimentation de la partie contrôle seront utilisés pour valider un des signaux INF ou AUTO sélectionné par le décodeur d'adresse.

Les figures 10, 11 et 12 symbolisent les opérations de test pouvant être effectuées sur le circuit intégré de la figure 9. Sur ces figures, le sérialiseur-désérialiseur 14 du circuit intégré 16 est relié par ses entrées-sorties parallèles à un appareil de test 15. Comme précédemment, le circuit 14 est relié aux émetteurs-récepteurs 12 dont un seul est représenté pour des raisons de clarté.

Selon une première possibilité illustrée à la figure 10, le circuit intégré 16 est testé après fabrication, avant d'être connecté aux lignes de transmission série. Dans ce cas, le testeur 15 commande la mise à 0 du signal INF de l'émetteur-récepteur à tester, ce qui entraîne que sa source de courant alimente les impédances d'adaptation dans leur configuration normale. Le testeur 15 commande ensuite l'émission par cet émetteur-récepteur d'un ensemble de données appliquées aux entrées parallèles du circuit 14. Le circuit 14 les convertit en données série et les transmet à l'émetteur-récepteur 12 sélectionné. En fonction des données série reçues, l'amplificateur 1 de l'émetteur-récepteur 12 reçoit des signaux de commande d'émission qui activent en conséquence les sources de courant alimentant les impédances d'adaptation.

Comme la ligne n'est pas branchée, la source S1 alimente seulement l'impédance d'adaptation R de la voie active, donc débite sur une impédance double de l'impédance équivalente qu'elle alimente lorsque l'émetteur-récepteur est en fonctionnement normal. Par conséquent, la tension V ou V* de la voie active prend la valeur - R.I. D'autre part, la tension V* ou V de la voie inactive prend la valeur - (R + r)i, c'est-à-dire pratiquement - RI/2.

Les tensions V et V* qui apparaissent sur les bornes de réception de l'amplificateur 1 reproduisent donc les signaux de commande d'émission qui, après mise en forme et conversion en données parallèles, sont reçus par l'appareil de test 15. Ce dernier effectue alors la comparaison entre les données parallèles émises initialement et celles reçues. S'il y a coïncidence, cela signifie que les circuits 13, 14 et 12 ont fonctionné correctement.

La même opération est ensuite effectuée en sélectionnant successivement les autres émetteurs-récepteurs du circuit.

Ainsi, grâce à la conception particulière des émetteurs-récepteurs, les opérations de test du circuit intégré sont très simples et permettent de vérifier non seulement le bon fonctionnement des émetteurs-récepteur mais aussi de tous les circuits annexes et intermédiaires tels que le sérialiseur-désérialiseur 14.

Des tests peuvent aussi être effectués alors que le circuit intégré est en place dans un système, ses émetteurs-récepteurs étant reliés aux lignes de transmission L.

Selon une première possibilité illustrée à la figure 11, l'appareil de test 15 commande la mise à 1 du signal INF de l'émetteur-récepteur à tester, ce qui force ses impédances d'adaptation à la valeur infinie. La source de courant de son amplificateur 1 alimente les seules lignes de transmission L. Comme les impédances d'adaptation ont une valeur égale à l'impédance caractéristique des lignes, nous nous retrouvons dans la même situation qu'à la figure 10 et le test peut être effectué de la même façon.

Dans ce cas, le test donne une indication supplémentaire sur l'intégrité des connexions entre l'émetteur-récepteur et les bornes du circuit intégré et des connexions entre les bornes et les lignes.

On peut noter que les deux tests précédents simulent le fonctionnement normal de façon rigoureuse dans le cas d'une transmission sans perte de courant.

Selon une autre possibilité illustrée à la figure 12, les émetteurs-récepteurs de deux circuits intégrés 16, 16' sont reliés entre eux par les lignes L et l'appareil de test commande la mise à 0 du signal INF de l'émetteur-récepteur du circuit intégré à tester 16 et la mise à 1 du signal INF de l'émetteur-récepteur correspondant de l'autre circuit intégré 16'.

Dans ce cas, l'émetteur-récepteur 12 du circuit 16 est dans sa configuration normale, tandis que celui du circuit 16' a ses impédances d'adaptation déconnectées.

Ainsi, la ligne L est ouverte à son extrémité qui est reliée au circuit 16' et par conséquent, les signaux émis par le circuit 16 sont transmis par la ligne vers le circuit 16', y sont réfléchis puis retransmis par la ligne vers le circuit 16. Il en résulte que la réflexion des signaux simule une émission du circuit 16' et une transmission par une ligne de longueur double de celle de la ligne réelle, avec possibilité de collisions entre les signaux émis et les signaux reçus.

Le test peut donc être effectué comme précédemment mais il fournira une indication supplémentaire sur l'intégrité de la ligne et des connexions entre la ligne et l'émetteur-récepteur de la station éloignée. De plus, ce test prend en compte les éventuelles pertes de courant au cours de la transmission. Enfin, l'effet de réflexion peut être exploité pour localiser les défauts de ligne par analyse des signaux de réception et du retard entre l'émission et la réception des signaux de test.

Il est intéressant de remarquer que les deux dernières possibilités de test peuvent avantageusement être combinées pour localiser les défauts. Ainsi, si le test selon la figure 12 révèle un défaut, le test selon la figure 11 indiquera si le défaut est dû ou non au circuit 16.

Dans le contexte d'un circuit d'interface parallèle-série, série-parallèle, les procédés de test précédents sont particulièrement avantageux dans le cas d'une liaison à haut débit car uniquement des signaux à basse fréquence sont échangés entre l'appareil de test et le circuit intégré à tester.

Selon une variante de réalisation du circuit intégré, on y inclut des circuits de test, commandés de l'extérieur, capables d'engendrer automatiquement des signaux de test parallèles, d'effectuer les comparaisons et de mémoriser les résultats de ces comparaisons dans des registres accessibles de l'extérieur.

Ce circuit de test comprendra un générateur de signaux de test, par exemple un générateur de signaux aléatoires, commandé par un circuit d'activation qui sera programmé pour déclencher l'envoi d'un nombre déterminé de mots de test. Comme l'horloge de réception est régénérée à partir des signaux série reçus, elle est indépendante de l'horloge d'émission. Aussi, les circuits de comparaison devront être conçus pour tenir compte des décalages entre les signaux émis et les signaux reçus. Ceci peut être réalisé au moyen de mémoires tampons. Cependant une réalisation moins encombrante consiste à associer aux circuits de comparaison un générateur de signaux de test identique à celui d'émission, programmé de la même façon et synchronisé par l'horloge de réception. Cette réalisation permet de supprimer les mémoires tampons ainsi que les circuits de resynchronisation qui seraient nécessaires autrement.

Le fait de prévoir les circuits de test à l'intérieur du circuit intégré présente le double avantage de ne pas nécessiter un appareil de test extérieur et de permettre une bien meilleure exhaustivité des tests. En effet, l'utilisation d'un appareil de test ralentirait considérablement les opérations de test à cause de la désynchronisation entre l'émission et la réception, ce qui implique de nombreuses opérations d'écriture et de lecture dans la mémoire de l'appareil de test.

La réalisation des générateurs de signaux de test, des moyens de comparaison et de mémorisation est à la portée de l'homme du métier et ne nécessite donc pas une description plus détaillée.

## Revendications

1. Circuit intégré comportant au moins une impédance intégrée réglable (R) et des moyens d'asservissement (3, 7, 8) pour régler ladite ou lesdites impédances (R) à une valeur fonction de celle d'une impédance de référence (Rc) extérieure au circuit intégré, lesdits moyens d'asservissement comportant une impédance d'asservissement (Ra) réglable, intégrée et dimensionnée en fonction des impédances intégrées réglables (R) et un comparateur d'impédance (3) comparant la valeur de l'impédance d'asservissement (Ra) à celle de l'impédance de référence (Rc), ledit comparateur (3) fournissant en fonction de cette comparaison un signal de réglage (AR) de ladite impédance d'asservissement (Ra) et desdites impédances intégrées réglables (R), ledit circuit intégré étant caractérisé en ce que ledit comparateur d'impédance (3) comporte des moyens d'alimentation en courant (Sa, Sc) de l'impédance d'asservissement (Ra) et de l'impédance de référence (Rc) et un comparateur de tension (11) sensible à la différence entre respectivement la tension aux bornes de l'impédance d'asservissement (Ra) et celle aux bornes de l'impédance de référence (Rc).

2. Circuit intégré selon la revendication 1, caractérisé en ce que ledit signal de règlage (AR) est un signal numérique.

3. Circuit intégré selon la revendication 2, caractérisé en ce que chaque impédance réglable (R, Ra) est réalisée au moyen d'une pluralité de résistances intégrées (P0-P6) branchées sélectivement en parallèle en fonction dudit signal de règlage numérique (AR).

4. Circuit intégré selon la revendication 3, caractérisé en ce que lesdites résistances intégrées sont dimensionnées de façon à ce que leurs activations successives conduisent à des valeurs régulièrement décroissantes de la résistance équivalente en résultant.

5. Circuit intégré selon la revendication 4, caractérisé en ce que ledit comparateur de tension (11) délivre un signal d'incrémentation (INC) et un signal de décrémentation (DEC) et active ledit signal d'incrémentation ou de décrémentation lorsque la différence de tension indique que la valeur de l'impédance d'asservissement (Ra) est respectivement inférieure ou supérieure à la valeur de l'impédance de référence (Rc) d'une valeur de seuil déterminée, en ce que lesdits moyens d'asservissement comportent un compteur-décompteur (6) et en ce que lesdits signaux d'incrémentation (INC) et de décrémentation (DEC) sont appliqués respectivement aux entrées d'incrémentation et de décrémentation dudit compteur-décompteur de façon à ce que son état constitue ledit signal de réglage numérique (AR) représentatif du nombre de résistances à sélectionner dans chaque impédance réglable (R, Ra).

6. Circuit intégré selon la revendication 5, caractérisé en ce que l'état du compteur-décompteur (6) est le nombre, codé en code de Gray, des résistances à sélectionner dans chaque impédance réglable (R, Ra), en ce que chaque impédance réglable (R, Ra) est commandée par un décodeur (7, 8) qui, en fonction dudit nombre codé, fournit les signaux de sélection (E0-E6) des résistances intégrées (P0-P6) constituant la ou lesdites impédances réglables (R, Ra).

7. Circuit intégré selon l'une des revendications 4 à 6, caractérisé en ce que lesdites résistances intégrées (P0-P6) sont formées des chemins drain-source de transistors à effet de champ dont les grilles sont commandées en fonction dudit signal de réglage numérique (AR).

8. Circuit de réception intégré comportant au moins un récepteur prévu pour être relié par une liaison de transmission à un émetteur, ladite liaison comportant au moins une ligne de transmission, ledit récepteur comportant des moyens d'amplification pour produire des signaux de réception (s, s*) en réponse aux signaux d'émission produits sur ladite liaison par ledit émetteur, lesdits moyens d'amplification comportant pour chaque ligne de transmission un amplificateur comprenant une impédance d'adaptation à la ligne et connectée à celle-ci ledit circuit intégré étant caractérisé en ce qu'il est conforme à l'une des revendications 1 à 7, lesdites impédances d'adaptation étant constituées par lesdites impédances intégrées réglables (R) et ladite impédance de référence (Rc) étant une impédance calibrée de valeur égale à l'impédance caractéristique de la ligne.

9. Système informatique comportant une pluralité d'unités fonctionnelles communiquant entre elles, caractérisé en ce que chaque unité est associée à au moins un circuit intégré selon la revendication 8, chaque récepteur dudit circuit intégré étant relié par une liaison de transmission à un émetteur appartenant à une autre unité fonctionnelle du système.

**Patentansprüche**

1. Integrierte Schaltung mit wenigstens einer einstellbaren integrierten Impedanz (R) sowie Regelmitteln (3, 7, 8), um die Impedanz oder die Impedanzen (R) auf einen vom Wert einer außerhalb der integrierten Schaltung befindlichen Referenzimpedanz (Rc) abhängigen Wert einzustellen, wobei die Regelmittel eine einstellbare, integrierte und in Abhängigkeit von den einstellbaren integrierten Impedanzen (R) dimensionierte Regelimpedanz (Ra) sowie einen den Wert der Regelimpedanz (Ra) mit demjenigen der Referenzimpedanz (Rc) vergleichenden Impedanzkomparator (3) aufweisen, wobei der Komparator (3) in Abhängigkeit von diesem Vergleich ein Regelungssignal (AR) der Regelimpedanz (Ra) und der einstellbaren integrierten Impedanzen (R) liefert, wobei die integrierte Schaltung dadurch gekennzeichnet ist, daß der Impedanzkomparator (3) Mittel zur Stromspeisung (Sa, Sc) der Regelimpedanz (Ra) und der Referenzimpedanz (Rc) sowie einen für die jeweils zwischen der Spannung an den Klemmen der Regelimpedanz (Ra) und derjenigen an den Klemmen der Referenzimpedanz (Rc) vorherrschenden Differenz empfindlichen Spannungskomparator (11) aufweist.

2. Integrierte Schaltung nach Anspruch 1 dadurch gekennzeichnet, daß das Regelungssignal (AR) ein digitales Signal ist.

3. Integrierte Schaltung nach Anspruch 2 dadurch gekennzeichnet, daß jede einstellbare Impedanz (R, Ra) mit Hilfe einer Vielzahl von integrierten, in Abhängigkeit von dem digitalen Regelungssignal (AR) selektiv parallelgeschalteten Widerständen (PO-P6) realisiert wird.

4. Integrierte Schaltung nach Anspruch 3 dadurch gekennzeichnet, daß die integrierten Widerstände derart dimensioniert sind, daß ihre aufeinanderfolgenden Aktivierungen regelmäßig abnehmende Werte des hieraus resultierenden äquivalenten Widerstandes zur Folge haben.

5. Integrierte Schaltung nach Anspruch 4 dadurch gekennzeichnet, daß der Spannungskomparator (11) ein Inkrementiersignal (INC) sowie ein Dekrementiersignal (DEC) liefert und das Inkrementier- oder Dekrementiersignal aktiviert, wenn die Spannungsdifferenz anzeigt, daß der Wert der Regelimpedanz (Ra) niedriger bzw. höher ist als der Wert der Referenzimpedanz (Rc) mit einem festgelegten Schwellenwert, daß die Regelmittel einen Vorwärts-Rückwärts-Zähler (6) aufweisen und daß das Inkrementiersignal (INC) und das Dekrementiersignal (DEC) an den Inkrementier- bzw. Dekrementiereingang des Vorwärts-Rückwärts-Zählers derart angelegt werden, daß dessen Zustand ein die Anzahl der in jeder einstellbaren Impedanz (R, Ra) auszuwählenden Widerstände repräsentierendes digitales Regelungssignal (AR) darstellt.

6. Integrierte Schaltung nach Anspruch 5 dadurch gekennzeichnet, daß der Zustand des Vorwärts-Rückwärts-Zählers (6) die im Gray-Code codierte Anzahl der in jeder einstellbaren Impedanz (R, Ra) auszuwählenden Widerstände ist, daß jede einstellbare Impedanz (R, Ra) mittels eines Decodierers (7, 8) gesteuert wird, der in Abhängigkeit von der codierten Anzahl die Auswahlsignale (E0-E6) der die einstellbare oder die einstellbaren Impedanzen (R, Ra) darstellenden integrierten Widerstände (P0-P6) liefert.

7. Integrierte Schaltung nach einem der Ansprüche 4 bis 6 dadurch gekennzeichnet, daß die integrierten Widerstände (P0-P6) von den Drain-Source-Strecken von Feldeffekttransistoren gebildet werden, deren Gitter in Abhängigkeit von dem digitalen Regelungssignal (AR) gesteuert werden.

8. Integrierte Empfangsschaltung mit wenigstens einem Empfänger, der mittels einer Übertragungsverbindung mit einem Sender verbunden werden soll, wobei die Verbindung wenigstens eine Übertragungsleitung aufweist, wobei der Empfänger Verstärkermittel zur Erzeugung von Empfangssignalen (s, s*) als Reaktion auf die in der Verbindung von dem Sender erzeugten Sendesignale aufweist, wobei die Verstärkermittel für jede Übertragungsleitung einen eine Impedanz zur Anpassung an die Leitung und mit dieser verbundenen aufweisenden Verstärker enthalten, wobei die integrierte Schaltung dadurch gekennzeichnet ist, daß sie einem der Ansprüche 1 bis 7 entspricht, wobei die Anpassungsimpedanzen von den einstellbaren integrierten Impedanzen (R) gebildet sind und wobei die Referenzimpedanz (Rc) eine kalibrierte Impedanz mit einem der charakteristischen Leitungsimpedanz entsprechenden Wert ist.

9. Informationssystem mit einer Vielzahl von miteinander kommunizierenden Funktionseinheiten, dadurch gekennzeichnet, daß jede Einheit mit wenigstens einer integrierten Schaltung gemäß Anspruch 8 verbunden ist, wobei jeder Empfänger der integrierten Schaltung durch eine Übertragungsverbindung mit einem zu einer anderen Funktionseinheit des Systems gehörenden Sender verbunden
ist.

**Claims**

1. An integrated circuit comprising at least one adjustable integrated impedance (R) and control means
(3, 7, 8) for adjusting said impedance(s) (R) to a
value that is a function of the value of a reference
impedance (Rc) outside the integrated circuit, said
control means comprising an integrated adjustable
control impedance (Ra) dimensioned as a function
of the adjustable integrated impedances (R) and an
impedance comparator (3) comparing the value of
the control impedance (Ra) with that of the reference
impedance (Rc), said comparator (3) supplying, as
a function of this comparison, a signal (AR) for
adjusting said control impedance (Ra) and said
adjustable integrated impedances (R), said integrated circuit being characterised in that said impedance comparator (3) comprises means (Sa, Sc) for
supplying a current to the control impedance (Ra)
and to the reference impedance (Rc) and a voltage
comparator (11) ) sensitive to the difference
between, respectively, the voltage at the terminals
of the control impedance (Ra) and that at the terminals of the reference impedance (Rc).

2. An integrated circuit according to Claim 1, characterised in that said adjustment signal (AR) is a digital
signal.

3. An integrated circuit according to Claim 2, characterised in that each adjustable impedance (R, Ra) is
produced by means of a plurality of integrated resistors (P0 - P6) connected selectively in parallel as a
function of said digital adjustment signal (AR).

4. An integrated circuit according to Claim 3, characterised in that said integrated resistors are dimensioned such that activating them in succession leads
to regularly decreasing values of the equivalent
resistance resulting therefrom.

5. An integrated circuit according to Claim 4, characterised in that said voltage comparator (11) ) furnishes an incrementing signal (INC) and a decrementing signal (DEC) and activates said incrementing or decrementing signal when the difference in
voltage indicates that the value of the control impedance (Ra) is respectively less or greater than the
value of the reference impedance (Rc) by a predetermined threshold value, in that said control means
comprise a reversible counter (6) and in that said
incrementing (INC) and decrementing (DEC) signals are applied respectively to the incrementing
and decrementing inputs of said reversible counter
such that its state constitutes said digital adjustment
signal (AR) representing the number of resistors to
be selected in each adjustable impedance (R, Ra).

6. An integrated circuit according to Claim 5, characterised in that the state of the reversible counter (6)
is the number, encoded in Gray code, of the resistors
be selected in each adjustable impedance (R, Ra),
in that each adjustable impedance (R, Ra) is controlled by a decoder (7, 8) which, as a function of
said encoded number, supplies the signals (E0 - E6)
for selecting the integrated resistors (P0 - P6) constituting said adjustable impedance(s) (R, Ra).

7. An integrated circuit according to one of Claims 4 to
6, characterised in that said integrated resistors (P0
- P6) are formed of the drain-source paths of fieldeffect transistors, the gates of which are controlled as
a function of said digital adjustment signal (AR).

8. An integrated reception circuit comprising at least
one receiver provided so as to be connected by a
transmission connection to an emitter, said connection comprising at least one transmission line, said
receiver comprising amplification means for producing reception signals (s, s*) in response to emission
signals produced on said connection by said emitter,
said amplification means comprising, for each transmission line, an amplifier comprising an impedance
for matching to the line and connected thereto, said
integrated circuit being characterised in that it is in
accordance with one of Claims 1 to 7, said matching
impedances being constituted by said adjustable
integrated impedances (R) and said reference
impedance (Rc) being a calibrated impedance of a
value equal to a characteristic impedance of the line.

9. A data-processing system comprising a plurality of
functional units communicating with one another,
characterised in that each unit is associated with at
least one integrated circuit according to Claim 8,
each receiver of said integrated circuit being connected by a transmission connection to an emitter
belonging to another functional unit of the system.

EP 0 504 062 B1

FIG.1

FIG. 2

# FIG. 3

FIG. 4

EP 0 504 062 B1

FIG. 5

18

EP 0 504 062 B1

FIG. 6

FIG. 7

19

FIG. 8

EP 0 504 062 B1

# FIG. 9

# FIG. 10

# FIG. 11

# FIG. 12